# EUROPEAN PATENT SPECIFICATION

(11) **EP 1 250 006 B1**
(45) Date of publication and mention of the grant of the patent: **10.05.2006**
(21) Application number: 02251857.5
(22) Date of filing: 15.03.2002
(51) Int. Cl.: H04N 7/14, H04N 7/173, H03B 5/12, H03D 7/16, H04N 5/00, H03J 5/24

(54) **Cable modem tuner**
Kabelmodemtuner
Circuit d'accord pour un cable modem

(30) Priority: 27.03.2001 JP 2001089778
(43) Date of publication of application: 16.10.2002
(73) Proprietor: SHARP KABUSHIKI KAISHA, Osaka 545-8522 (JP)
(72) Inventor: Matsuura, Syuuji, Ikoma-shi, Nara (JP)
(74) Representative: Brown, Kenneth Richard

(56) References cited:
- EP-A- 0 911 962
- EP-A- 0 920 121
- EP-A- 1 128 556
- US-A- 4 352 209
- US-A- 4 569 084
- US-B1- 6 169 569

## Description

### BACKGROUND OF THE INVENTION

### Field of the Invention

The present invention relates to a cable modem tuner. More specifically, the present invention relates to a cable modem tuner mounted in a cable modem used for high speed data communication at home, utilizing an unused channel of cable television (hereinafter referred to as CATV).

### Description of the Background Art

In the CATV, introduction of HFC (Hybrid Fiber/Coax) has been in progress, in which the main network is implemented by optical fibers. This system attempts to provide broad-band data communication service of several M bits/sec at home. Utilizing this technique, it is possible to realize high speed data line having the transmission rate of 30M bits/sec with the bandwidth of 6MHz using 64QAM (Quadrature Amplitude Modulation), which may not be called the state of the art anymore. The cable modem is used in this system. It realizes high speed data communication of 4M bits/sec to 27M bits/sec, utilizing an unused channel of CATV.

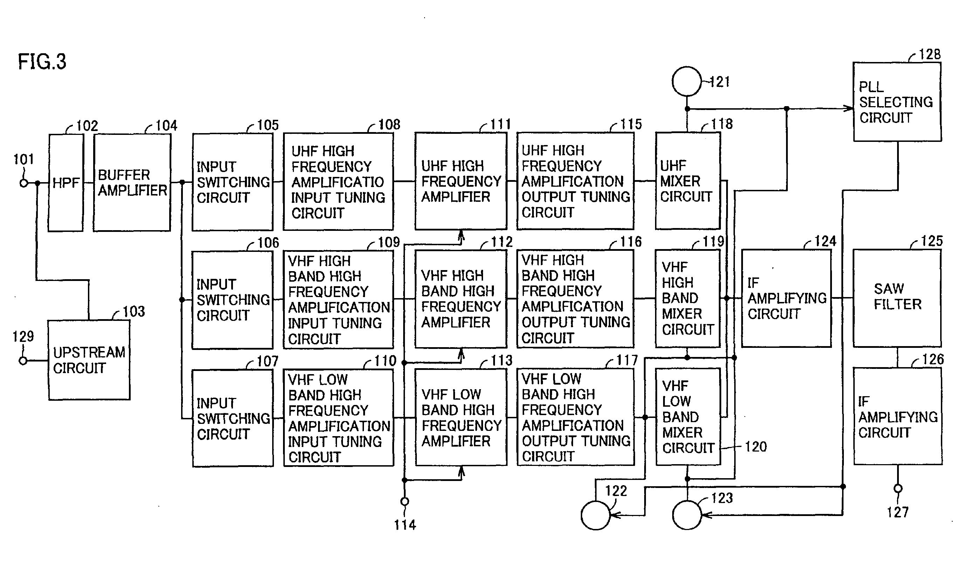

Fig. 3 is a block diagram of a conventional cable modem tuner. As for the CATV signals, an up signal transmitted to a CATV station, not shown, from the cable modem tuner has the frequency of 5MHz to 42MHz, while a down signal transmitted from the CATV station to the cable modem tuner has the frequency of 54MHz to 860MHz, and the signal is transmitted to a cable network through an input terminal 101 of the tuner. The up signal transmitted from the cable modem is received by a data receiver of the CATV station (system operator), and enters a computer of the center. In the cable modem, a data signal subjected to quadrature phase shift keying (QPSK) from a QPSK transmitter, not shown, is input to data terminal 129 as the up signal. The data signal is transmitted through an up stream circuit 103 and a data terminal 129 to the CATV station.

The down signal is applied through an HPF (high pass filter) 102, which is an IF (intermediate frequency) filter having the attenuation range of 5 to 42MHz and a pass band of not lower than 54MHz of the tuner shown in Fig. 3 to a buffer amplifier 104, and applied to various circuits of the succeeding stages.

The circuits of the succeeding stages constitute receiving circuits for an UHF band (B3 band) receiving the frequency of 470 to 860MHz, a VHF HIGH band (B2 band) receiving the frequency of 170 to 470MHz and a VHF LOW band (B1 band) receiving the frequency of 54 to 170MHz, respectively. Band ranges are not limited to those specified above.

The cable modem tuner further includes, in addition to the receiving circuits mentioned above, IF amplifying circuits 124 and 126, an SAW filter 125, an IF output terminal 127 and a PLL channel selection circuit 128.

The receiving circuits for the B1 to B3 bands mentioned above include: input switching circuits 105, 106 and 107 to which a method of switching utilizing a switching diode or a filtering by band division is applied, respectively; an UHF high frequency amplification input tuning circuit 108, a VHF HIGH BAND high frequency amplification input tuning circuit 109 and a VHF LOW BAND high frequency amplification input tuning circuit 110, respectively; a UHF high frequency amplifier 111, a VHF HIGH BAND high frequency amplifier 112 and a VHF LOW BAND high frequency amplifier 113, respectively; a UHF high frequency amplification output tuning circuit 115, a VHF HIGH BAND high frequency amplification output tuning circuit 116 and a VHF LOW BAND high frequency amplification output tuning circuit 117, respectively; a UHF mixer circuit 118, a VHF HIGH BAND mixer circuit 119 and a VHF LOW BAND mixer circuit 120, respectively; and a UHF oscillation circuit 121, a VHF HIGH BAND oscillation circuit 122 and a VHF LOW BAND oscillation circuit 123 corresponding to the mixer circuits, respectively.

Dual gate type MOSFET element is generally used for high frequency amplifiers 111, 112 and 113, and an AGC voltage from an AGC terminal is applied to the gate electrode of the element. Therefore, the gain of these amplifiers is controlled by the AGC voltage.

Input switching circuits 105, 106 and 107 receive as inputs the signals of B1 to B3 bands, and selectively output the received signals in the prescribed frequency bands.

High frequency amplification input tuning circuits 108, 109 and 110 tune respective received signals selectively output from input switching circuits 105, 106 and 107 to desired frequencies (frequencies of desired channels) in respective bands, using a tuning coil, for example, and output the results.

High frequency amplifiers 111, 112 and 113 amplify, at respective bands, output signals from high frequency amplification input tuning circuits 108, 109 and 110 so as to prevent degradation of SN ratio such as signal distortion, based on a voltage level at the AGC terminal 114 at which the AGC (automatic gain control) voltage is supplied, and output the results. An RF (radio frequency) AGC voltage supplied to AGC terminal is supplied to the gate electrodes of dual gate type MOSFETs of high frequency amplifiers 111, 112 and 113 so that the high frequency amplifiers operate with full power gain when the input signal level is µ or lower, and that an output level of the corresponding tuner is always kept constant when the input signal level is µ or upper. Thus, degradation of SN ratio such as distortion of the signal can be prevented.

High frequency amplification output tuning circuits 115, 116 and 117 receive output signals from high frequency amplifiers 111, 112 and 113, tune these output signals to desired frequencies in respective bands, using a tuning coil, for example, and output the results.

Local oscillation circuits 121, 122 and 123 oscillate stably to provide prescribed intermediate frequencies corresponding to respective bands. The circuits 118, 119 and 120 convert the signals output from high frequency amplification output tuning circuits 115, 116 and 117, respectively, to desired intermediate frequency signals, based on the oscillation signals from the corresponding local oscillation circuits. Therefore, local oscillation circuits 121, 122 and 123 and mixer circuits 118, 119 and 120 form frequency converting circuits for respective bands.

Thereafter, output signals of respective receiving circuits are amplified to prescribed levels by IF amplifying circuit 124, subjected to frequency conversion to prescribed levels by SAW filter 125 and IF amplifying circuit 126, and output to IF output terminal 127.

The operation of the cable modem tuner shown in Fig. 3 will be described in detail. A down signal passes through HPF 102, and applied to input switching circuits 105, 106 and 107. Of the three receiving circuits, only that receiving circuit of which operation frequency corresponds to the frequency of the down signal operates, and other receiving circuits do not operate. The operation is common to all receiving circuits.

The receiving circuits of each band will be described in the following.

The CATV signal is passed through input switching circuits 105, 106 and 107 as well as high frequency amplification input tuning circuits 108, 109 and 110, amplified by high frequency amplifiers 111, 112 and 113, and provided as a received signal, through high frequency amplification output tuning circuits 115, 116 and 117.

Thereafter, the received signal is converted to a desired intermediate frequency signal by mixer circuit 118, 119 and 120 and local oscillation circuits 121, 122 and 123, subjected to LOW IF conversion by IF amplifying circuits 124, 126 and SAW filter 125, and provided to output terminal 127.

The above described series of operations is realized as power supply to respective bands is switched by an input switching circuit for switching bands that operates in accordance with the band characteristic, simultaneously with channel selection based on the channel selection data from a CPU, not shown, to PLL channel selection circuit 128.

Japanese Patent Laying-Open No. 10-304261 discloses a cable modem tuner having a similar configuration. United States Patent No. 6,169,569 describes an example of a single conversion type tuner.

In the above described conventional cable modem tuner, single conversion method is generally used in which a received signal is subjected to frequency conversion and taken out as an intermediate frequency signal. However, there are various problems as will be discussed in the following, to provide the QAM signal, which is a digital signal, as an intermediate frequency signal to the QAM demodulating circuit.

First, high frequency amplifiers 111, 112 and 113 are adapted to have the function of high frequency AGC. Therefore, there is about -50dBc of distortion IM (inter modulation) of CTB (composit triple beat) and CSO (composit system order beat) particularly with the gain attenuation of -10 to -20dB, which must be improved.

As high frequency amplification input tuning circuits 108, 109 and 110 and high frequency amplification output tuning circuits 115, 116 and 117 are provided, sensitivity deviation in the reception band is generally 10dB or higher, which must also be improved. Further, as the tuning circuit system is used, there is at least -50dBc of video signal removal ratio. This must also be improved.

As high frequency amplification input tuning circuits 108, 109 and 110 are provided in the input circuit, it is difficult to compensate for an input return loss over the entire reception band. Further, there is a local leakage of -10 to 20dBmV, which does not satisfy DOCSIS (Data Over Cable Service Interface Specification) required standard of -40 dBm V.

Air core coils are used in oscillation circuit of local oscillation circuits 121, 122 and 123, high frequency amplification input tuning circuits 108, 109, 110 and high frequency amplification output tuning circuits 115, 116 and 117. Further, trucking adjustment is necessary between each of the tuning circuits and the local oscillation circuits. Further, as the air coil is used, advantages of IC implementation cannot fully be utilized, and reduction in size has been difficult.

### SUMMARY OF THE INVENTION

It is desirable to provide a cable modem tuner employing a double conversion method, to solve the problems experienced in the single conversion method.

Accordingly there is provided a cable modem tuner as set out in claim 1.

The down signal is converted by an up converter, to a first intermediate frequency signal of higher frequency, the first intermediate frequency signal output from the up converter is selected by a SAW filter, and the first intermediate frequency signal selected by the SAW filter is converted by a down converter to a second intermediate frequency signal of lower frequency and the result is output. Therefore, transmission distortion can be improved as compared with the conventional single converter.

Further, the up converter includes a broadband high frequency amplifying circuit having a reception frequency band, for amplifying the down signal, a gain variable broadband variable gain amplifying circuit receiving the down signal from the broadband high frequency amplifying circuit, a local oscillation circuit outputting a local oscillation signal having higher frequency than the down signal, and a mixer circuit mixing the down signal output from the broadband variable gain amplifying circuit with the local oscillation signal output from the local oscillation circuit.

Preferably the cable modem further comprises an upstream circuit for transmitting a data signal to a CATV station, wherein said up stream circuit includes: a gain controllable gain control circuit for receiving said data signal; a power amplifying circuit for power-amplifying a gain controlled data signal; and a control circuit for controlling the gain of said gain control circuit.

Therefore, in the upstream circuit, the data signal of which gain is controlled by the gain controllable gain control circuit is power-amplified, and transmission/interruption of the data signal is controlled. Therefore, power loss can be reduced, and spurious emission can be improved.

Preferably, the down converter includes a first intermediate frequency amplifying circuit amplifying the first intermediate frequency signal selected by the SAW filter, a local oscillation circuit outputting a local oscillation signal having lower frequency than the first intermediate frequency signal, a mixer circuit mixing the first intermediate frequency signal output from the first intermediate frequency amplifying circuit with the local oscillation signal output from the local oscillation circuit and outputting a second intermediate frequency signal, a second intermediate frequency amplifying circuit amplifying the second intermediate frequency signal output from the mixer circuit, and a filter for selecting the second intermediate frequency signal output from the second intermediate frequency amplifying circuit.

Preferably, the cable modem tuner further includes a gain variable intermediate frequency gain amplifying circuit receiving the second intermediate frequency signal from the second intermediate frequency amplifying circuit.

Further, the filter includes a bandpass filter formed of an oscillation circuit including a strip line, a print coil or an air core coil.

Preferably, the cable modem tuner including an upstream circuit for transmitting a data signal to a CATV (Cable Television) station and a receiving unit for receiving a down signal from the CATV station, including a duplexer for branching the data signal to the CATV station and the down signal from the CATV station, a return pass circuit outputting the data signal to the duplexer, and a receiving unit receiving the down signal branched by the duplexer.

In order that the present invention be more readily understood, a specific embodiment thereof will now be described with reference to the accompanying drawings.

### BRIEF DESCRIPTION OF THE DRAWINGS

Fig. 1 is a block diagram of an embodiment of the present invention.
Figs. 2A and 2B show examples of the SAW filter shown in Fig. 1.
Fig. 3 is a block diagram of a conventional cable modem tuner.

### DESCRIPTION OF THE PREFERRED EMBODIMENTS

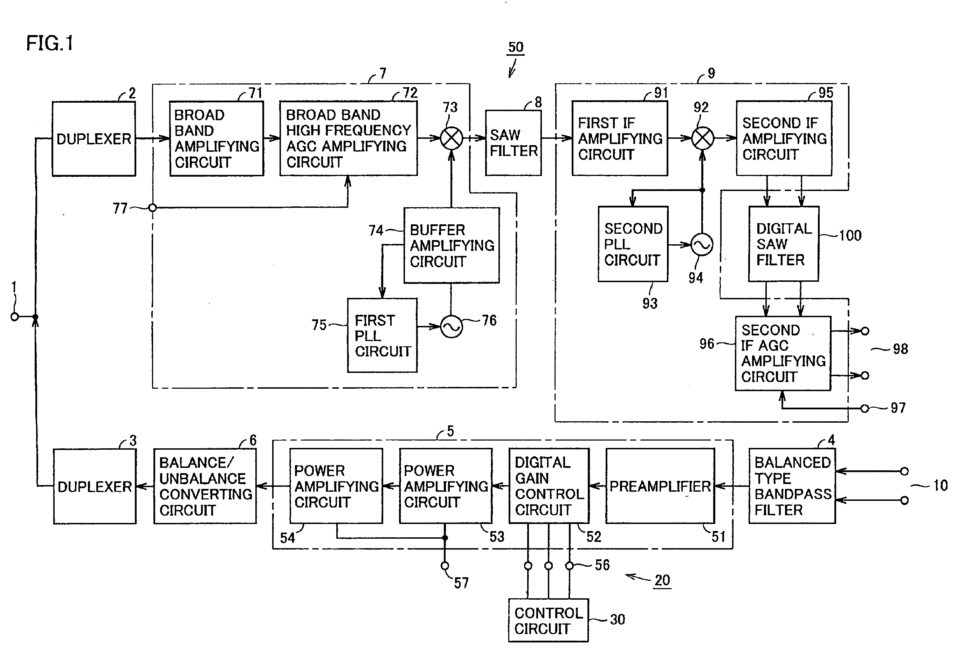

Referring to Fig. 1, as for the CATV signal, an up signal has the frequency of 5 to 42MHz, and a down signal has a frequency of 54 to 860MHz, and an input/output terminal 1 is connected to a cable network. The up signal is input to a return pass signal input terminal 10. The up signal is balanced data that has been subjected to quadrature phase shift keying from a QPSK transmitter, not shown, and the data is applied to an upstream circuit 20. The data has its band limited by a balanced type bandpass filter 4 included in upstream circuit 20, and then input to a return pass amplifying circuit IC5.

Return pass amplifying circuit IC5 includes a preamplifier 51, a digital gain control circuit 52 and power amplifying circuits 53 and 54. Return pass amplifying circuit IC5 is provided to reduce power loss and to reduce spurious emission. To a control signal input terminal 56 of digital gain control circuit 52, a control signal for controlling gain is input from a control circuit 30. To a control signal input 57 of power amplifying circuits 53 and 54, a control signal for controlling transmission/interruption of data is applied.

The data output from return pass amplifying circuit IC5 is converted to an unbalanced signal by balance/unbalance converting circuit 6 and output, through a duplexer 3 formed of a low pass filter, to input/output terminal 1.

On the other hand, the down signal is input to input/output terminal 1, and input through a duplexer 2 formed of a high pass filter, to an up converter IC7 included in a receiving unit 50. Up converter IC7 includes a band amplification circuit 71, a broadband high frequency AGC amplifying circuit 72, a balanced type mixer circuit 73, a buffer amplifying circuit 74, a first PLL circuit 75 and a voltage variable first local oscillation circuit 76, and the up converter converts the down signal to a first intermediate frequency signal having higher frequency. An RF AGC control signal is input to an RF AGC terminal 77.

The first intermediate frequency signal output from up converter IC7 is applied through an SAW filter 8 to down converter IC9. Down converter IC9 includes a first IF amplifying circuit 91, a mixer circuit 92, a second PLL circuit 93, a voltage variable second local oscillation circuit 94, a second IF amplifying circuit 95 and a second IF AGC amplifying circuit 96, and the down converter IC converts the first intermediate frequency signal to a second intermediate frequency signal of lower frequency. An IF AGC control signal is input to an IF AGC terminal 97. An output of the second IF AGC amplifying circuit 96 is applied as an IF signal of a QAM demodulating circuit, not shown, from an output terminal 98.

A specific operation of the cable modem tuner shown in Fig. 1 will be described.

The signal from the QPSK modulator as the up signal is input to return pass input terminal 10, n th order harmonics component is removed by balanced type bandpass filter 4, and power amplification of about 30dB is attained by return pass amplifying circuit IC5. Digital gain control circuit 52 varies the output level of +58dBmV to +5dBmV, 1dB by 1dB. For this control, a control signal is input in accordance with 3 Wire Bus control method, to the control signal input terminal 56 of digital gain control circuit 52. At power amplifying circuits 53 and 54, data transmission/interruptions is controlled by the control signal input to control input terminal 57.

The return pass signal is subjected to impedance conversion and converted to an unbalanced signal by balance/unbalance converting circuit 6, combined with the down signal by duplexer 3, and output from input/output terminal 1.

The down signal is input through duplexer 2 to up converter IC 7, amplified by broadband amplifying circuit 71, and at broad band high frequency AGC amplifying circuit 72, subjected to broadband RF AGC control by an AGC control signal applied from a QAM demodulating circuit prior to RF AGC terminal 77. The down signal is mixed with the local oscillation signal generated by the first PLL circuit, the voltage variable first local oscillation circuit 76 and buffer amplifying circuit 74 at balanced type mixer circuit 73, and subjected to frequency conversion, to be the first intermediate frequency signal. When the received signal has the frequency of 54 to 860MHz, the first intermediate frequency signal is selected to have about 1100 MHz.

The first intermediate frequency signal passes through SAW filter 8, and applied to down converter IC 9. The first intermediate frequency signal is amplified by the first IF amplifying circuit 91, mixed with the local oscillation signal generated by the second PLL circuit 93 and a voltage variable second local oscillation circuit 94 at mixer circuit 92, and subjected to frequency conversion to be a second intermediate frequency signal. The second intermediate frequency signal is amplified by the second IF amplifying circuit 95, applied to a digital SAW filter 10 by which out-of-band noise is removed, and then applied to the second IF AGC amplifying circuit 96. The second intermediate frequency signal is subjected to gain control based on the AGC control signal from QAM demodulating circuit applied to IF AGC terminal 97, and output from output terminal 98.

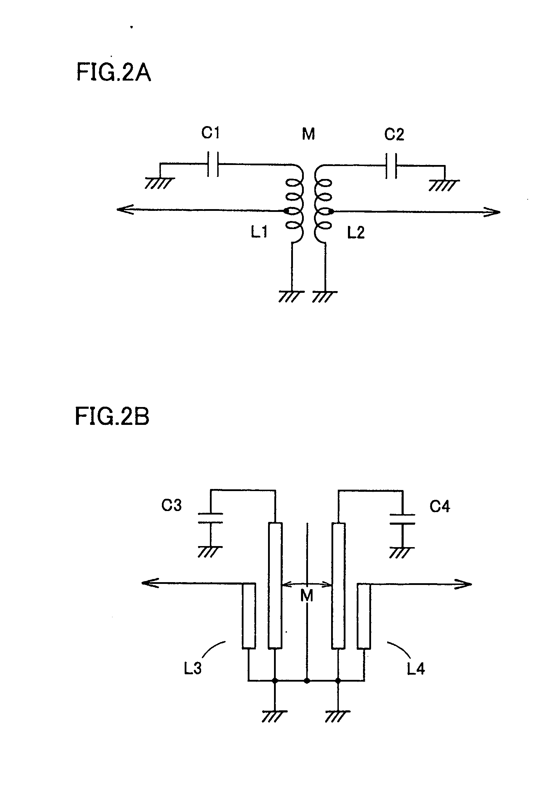

Figs. 2A and 2B show examples of the SAW filter shown in Fig. 1. The SAW filter 8 is implemented as a lumped constant type filter such as shown in Fig. 2A, or an oscillation circuit of strip lines shown in Fig. 28. More specifically, the lumped constant type filter shown in Fig. 2A includes oscillating inductors L1, L2 formed of air core coils and oscillating capacitors C1, C2, and oscillating inductors L1 and L2 are inductively coupled (M).

The filter shown in Fig. 2B includes oscillating inductors L3, L4 formed of a strip line or print coil, and oscillating capacitors C3, C4, and the oscillating inductors L3 and L4 are inductively coupled (M).

As described above, according to the present embodiment, a double conversion type channel selection circuit is employed, and balanced type mixer circuit 73 is effective against transmission distortion. Therefore, the transmission distortion can be improved by more than 6dB as compared with the conventional single mixer. Further, CSO and CTB as IM can be improved to -57dB or higher.

As the double conversion type channel selection circuit is employed and deviation in the reception band depends on the frequency characteristic of the conversion gain, that is, the performance of balanced type mixer circuit 73. Therefore, sensitivity deviation can be improved to be within -3dB as compared with the prior art.

Further, the video signal removal ratio is determined by the transmission characteristics of SAW filter 8, and it can be improved to be 60dB or higher, as compared with the prior art.

As the broad band amplifying circuit 71 is adopted in the tuner input circuit, the input return loss can be improved to 6dB or higher, over the entire reception band.

As the oscillation frequency of the local oscillation circuit 76 of up converter IC7 is set to be out of the reception band, the spurious emission can be improved to -40dBmV or lower. Further, as a return pass circuit is contained, power loss can be reduced, and spurious emission can be improved to be -50dBmV or lower.

Further, by implementing the up converter unit and down converter unit in ICs, and by employing SAW filter 9 in the first intermediate frequency amplifying unit, area occupation can be significantly improved, and packaging area can be reduced by more than 30%, as compared with the conventional circuit configuration implemented by discrete parts.

As described above, according to the embodiment of the present invention, in the up stream circuit, the data signal having its gain controlled by the controllable gain control circuit is power-amplified, and transmission/interruption of the data signal is controlled. Further, power loss can be reduced and spurious emission is improved.

Further, at the receiving unit, the down signal is converted by an up converter to the first intermediate frequency signal of higher frequency, the first intermediate frequency signal output from the up converter is selected by a filter, and the first intermediate frequency signal selected by the filter is converted by a down converter to a second intermediate frequency signal of lower frequency to be output. Therefore, as compared with the conventional single converter, transmission distortion can be improved.

Further, in the up converter, the down signal is amplified by a broad band high frequency amplifying circuit having a reception frequency band, the down signal is received by a gain variable broadband variable gain amplifying circuit, and the down signal output from the broadband variable gain amplifying circuit is mixed with a local oscillation signal having a frequency higher than the frequency of the down signal, and therefore spurious emission can be improved.

Further, as the up converter unit and the down converter unit are implemented by ICs, occupation ratio can significantly be improved, and packaging area is reduced, as compared with the conventional circuit configuration of discrete parts.

Although the present invention has been described and illustrated in detail, it is clearly understood that the same is by way of illustration and example only and is not to be taken by way of limitation, the scope of the present invention being limited only by the terms of the appended claims.

## Claims

1. A cable modem tuner comprising:
a down stream circuit (50) for receiving a down signal from a CATV (cable television) station, wherein said down stream circuit includes:
an up converter (7) for converting the down signal to a first intermediate frequency signal of higher frequency;
a SAW filter (8) for selecting the first intermediate frequency signal output from said up converter; and
a down converter (9) for converting the first intermediate frequency signal selected by said SAW filter to a second intermediate frequency signal of lower frequency and outputting the resulting signal, wherein
said SAW filter (8) comprises an oscillation circuit that includes a print coil or an air core coil
said cable modem tuner further comprising:
an upstream circuit (20) for transmitting a data signal to a CATV station, wherein said upstream circuit includes:
a gain controllable gain control circuit (52) for receiving said data signal;
at least one power amplifying circuit (53, 54) for power-amplifying the data signal having been gain controlled by said gain control circuit; and
a control circuit (30) for transmitting a control signal (57) to said at least one power amplifying circuit for controlling transmission/interruption of said data signal.

2. A cable modem tuner according to claim 1, wherein
said up converter includes:
a broadband high frequency amplifying circuit having a reception frequency band, for amplifying said down signal;
a gain variable broadband variable gain amplifying circuit (71) receiving the down signal from said broad band high frequency amplifying circuit;
a local oscillation circuit (74-76) outputting a local oscillation signal having higher frequency than said down signal; and
a mixer circuit (73) mixing the down signal output from said broadband variable gain amplifying circuit with the local oscillation signal output from said local oscillation circuit.

3. A cable modem tuner according to claim 1, wherein
said down converter includes:
a first intermediate frequency amplifying circuit (91) amplifying the first intermediate frequency signal selected by said SAW filter;
a local oscillation circuit (92-94) outputting a local oscillation signal having lower frequency than said first intermediate frequency signal;
a mixer circuit (92) mixing the first intermediate frequency signal output from said first intermediate frequency amplifying circuit with the local oscillation signal output from said local oscillation circuit and outputting a second intermediate frequency signal;
a second intermediate frequency amplifying circuit (95) amplifying the second intermediate frequency signal output from said mixer circuit; and
a filter (100) for selecting said second intermediate frequency signal output from said second intermediate frequency amplifying circuit.

4. A cable modem tuner according to claim 3, further comprising a gain variable intermediate frequency gain amplifying circuit (96) receiving the second intermediate frequency signal from said second intermediate frequency amplifying circuit.

5. A cable modem tuner according to claim 1, comprising;
a duplexer (2, 3) for branching the data signal to said CATV station and the down signal from the CATV station;
a return pass circuit (5) for outputting said data signal to the duplexer; and
a receiving unit (7-9) for receiving the down signal branched by said duplexer.

## Patentansprüche

1. Kabelmodemtuner mit:
- einem stromabwärtigen Schaltkreis (150) zum Empfangen eines Abwärtssignals von einer CATV(Kabelfernseh)-Station, wobei dieser stromabwärtige Schaltkreis Folgendes aufweist:
-- einen Aufwärtswandler (7) zum Wandeln des Abwärtssignals in ein erstes Zwischenfrequenzsignal höherer Frequenz;
-- ein SAW-Filter (8) zum Auswählen des vom Aufwärtswandler ausgegebenen ersten Zwischenfrequenzsignals; und
-- einen Abwärtswandler (9) zum Wandeln des durch das SAW-Filter ausgewählten ersten Zwischenfrequenzsignals in ein zweites Zwischenfrequenzsignal niedrigerer Frequenz und zum Ausgeben des sich ergebenden Signals;
-- wobei das SAW-Filter (8) über eine Oszillatorschaltung mit einer gedruckten Spule oder einer Luftkernspule verfügt; wobei dieser Kabelmodemtuner ferner mit Folgendem versehen ist:
- einem stromaufwärtigen Schaltkreis (20) zum Übertragen eines Datensignals an eine CATV-Station, wobei dieser stromaufwärtige Schaltkreis Folgendes aufweist:
-- eine Verstärkungssteuerschaltung (52) mit steuerbarer Verstärkung zum Empfangen des Datensignals;
-- mindestens eine Leistungs-Verstärkerschaltung (53, 54) zur Leistungsverstärkung des Datensignals, deren Verstärkung durch die Verstärkungssteuerschaltung verstärkt wird; und
-- eine Steuerschaltung (30) zum Übertragen eines Steuerungssignals (57) an die mindestens eine Leistungs-Verstärkerschaltung, um die Übertragung/Unterbrechung des Datensignals zu steuern.

2. Kabelmodemtuner nach Anspruch 1, bei dem der Aufwärtswandler Folgendes aufweist:
- eine breitbandige Hochfrequenz-Verstärkerschaltung mit einem Empfangsfrequenzband zum Empfangen des Abwärtssignals;
- eine breitbandige Verstärkerschaltung (71) mit variabler Verstärkung, die das Abwärtssignal von der breitbandigen Hochfrequenz-Verstärkerschaltung empfängt;
- eine Ortsoszillatorschaltung (74-76) zum Ausgeben eines Ortsoszillatorsignals mit höherer Frequenz als der des Abwärtssignals; und
- eine Mischschaltung (73), die das von der breitbandigen Verstärkerschaltung mit variabler Verstärkung ausgegebene Abwärtssignal mit dem Ortsoszillatorsignal von der Ortsoszillatorschaltung mischt.

3. Kabelmodemtuner nach Anspruch 1, bei dem der Abwärtswandler Folgendes aufweist:
- eine erste Zwischenfrequenz-Verstärkerschaltung (91) zum Verstärken des durch das SAW-Filter ausgewählten ersten Zwischenfrequenzsignals;
- eine Ortsoszillatorschaltung (92-94) zum Ausgeben eines Ortsoszillatorsignals mit niedrigerer Frequenz als der des ersten Zwischenfrequenzsignals;
- eine Mischschaltung (92) zum Mischen des von der ersten Zwischenfrequenz-Verstärkerschaltung ausgegebenen ersten Zwischenfrequenzsignals mit dem von der Ortsoszillatorschaltung ausgegebenen Ortsoszillatorsignal und zum Ausgeben eines zweiten Zwischenfrequenzsignals;
- eine zweite Zwischenfrequenz-Verstärkerschaltung (95) zum Verstärken des von der Mischschaltung ausgegebenen zweiten Zwischenfrequenzsignals; und
- ein Filter (100) zum Auswählen des von der zweiten Zwischenfrequenz-Verstärkerschaltung ausgegebenen zweiten Zwischenfrequenzsignals.

4. Kabelmodemtuner nach Anspruch 3, ferner mit einer Zwischenfrequenz-Verstärkerschaltung (96) mit variabler Verstärkung zum Empfangen des zweiten Zwischenfrequenzsignals von der zweiten Zwischenfrequenz-Verstärkerschaltung.

5. Kabelmodemtuner nach Anspruch 1 mit:
- einem Duplexer (2, 3) zum Verzweigen des Datensignals an die CATV-Station und des Abwärtssignals von dieser;
- einer Rückwärtsdurchlassschaltung (5) zum Ausgeben des Datensignals an den Duplexer; und
- einer Empfangsschaltung (7-9) zum Empfangen des durch den Duplexer verzweigten Abwärtssignals.

## Revendications

1. Tuner de modem câble comprenant :
un circuit aval (50) permettant de recevoir un signal aval d'une station de CATV (télévision par câble), dans lequel ledit circuit aval comprend :
un convertisseur élévateur (7) permettant de convertir le signal aval en un premier signal à fréquence intermédiaire de fréquence supérieure ;
un filtre SAW (8) permettant de sélectionner le premier signal à fréquence intermédiaire généré par ledit convertisseur élévateur ; et
un convertisseur abaisseur (9) permettant de convertir le premier signal à fréquence intermédiaire sélectionné en un second signal à fréquence intermédiaire de fréquence inférieure et de générer le signal qui en résulte, dans lequel
ledit filtre SAW (8) comprend un circuit oscillateur qui comprend une bobine imprimée ou une bobine à noyau d'air ;
ledit tuner de modem câble comprenant en outre:
un circuit amont (20) permettant de transmettre un signal de données à une station de CATV, ledit circuit amont comprenant :
un circuit de commande du gain (52), dont le gain est commandable, pour recevoir ledit signal de données ;
au moins un circuit d'amplification de puissance (53, 54) pour amplifier la puissance du signal de données dont le gain a été commandé par ledit circuit de commande du gain ; et
un circuit de commande (30) pour transmettre un signal de commande (57) audit circuit d'amplification de la puissance pour commander la transmission/interruption dudit signal de données.

2. Tuner de câble modem selon la revendication 1, dans lequel
ledit convertisseur élévateur comprend :
un circuit d'amplification de haute fréquence à large bande ayant une bande de fréquence de réception pour amplifier ledit signal aval ;
un circuit d'amplification à gain variable et à large bande (71) pour recevoir le signal aval provenant dudit circuit d'amplification de haute fréquence à large bande ;
un circuit oscillateur local (74-76) générant un signal d'oscillation local présentant une fréquence supérieure à celle dudit signal aval ; et
un circuit de mélange (73) qui mélange le signal aval provenant dudit circuit d'amplification à gain variable et à large bande avec le signal d'oscillation local provenant dudit circuit oscillateur local.

3. Tuner de câble modem selon la revendication 1, dans lequel
ledit convertisseur abaisseur comprend :
un premier circuit d'amplification de fréquence intermédiaire (91) permettant d'amplifier le premier signal à fréquence intermédiaire sélectionné par ledit filtre SAW ;
un circuit oscillateur local (92-94) générant un signal d'oscillation local présentant une fréquence inférieure à celle dudit premier signal à fréquence intermédiaire ;
un circuit de mélange (92) permettant de mélanger le premier signal à fréquence intermédiaire provenant dudit premier circuit d'amplification de fréquence intermédiaire avec le signal d'oscillation local provenant dudit circuit oscillateur local et de générer un second signal à fréquence intermédiaire ;
un second circuit d'amplification de fréquence intermédiaire (95) permettant d'amplifier le second signal à fréquence intermédiaire provenant dudit circuit de mélange ; et
un filtre (100) permettant de sélectionner ledit signal à fréquence intermédiaire provenant dudit second circuit d'amplification de fréquence intermédiaire.

4. Tuner de câble modem selon la revendication 1, comprenant en outre un circuit d'amplification du gain de fréquence intermédiaire à gain variable (96) permettant de recevoir le second signal à fréquence intermédiaire provenant dudit circuit d'amplification de fréquence intermédiaire.

5. Tuner de modem câble selon la revendication 1, comprenant :
un duplexeur (2, 3) permettant d'orienter le signal de données vers ladite station de CATV et le signal aval à partir de la station CATV ;
un circuit de retour (5) permettant d'envoyer ledit signal de données vers ledit duplexeur ; et
une unité de réception (7-9) permettant de recevoir le signal aval orienté par ledit duplexeur.
